# EUROPÄISCHE PATENTSCHRIFT

(11) **EP 2 631 332 B1**
(45) Veröffentlichungstag und Bekanntmachung des Hinweises auf die Patenterteilung: **20.04.2016**
(21) Anmeldenummer: 13155786.0
(22) Anmeldetag: 19.02.2013
(51) Int. Cl.: C23C 16/30, C23C 18/16, C23C 4/10, C23C 18/12, C23C 18/31, C23C 16/453, C23C 18/36, C23C 18/40, C25D 3/38

(54) **Verfahren zur Metallisierung eines Substrats**
Method for metalizing a substrate
Procédé de métallisation d'un substrat

(30) Priorität: 21.02.2012 DE 102012202627
(43) Veröffentlichungstag der Anmeldung: 28.08.2013
(73) Patentinhaber: Innovent e.V., 07745 Jena (DE)
(72) Erfinder: Pfuch, Andreas, 99510 Apolda (DE); Schmidt, Jürgen, 07745 Jena (DE); Horn, Kerstin, 07749 Jena (DE); Beier, Oliver, 07407 Rudolstadt (DE); Ramm, Max, 07768 Kahla (DE)
(74) Vertreter: Liedtke, Klaus

(56) Entgegenhaltungen:
- DE-A1- 3 440 176
- DE-A1-102009 030 876
- US-A1- 2007 190 362

## Beschreibung

Die Erfindung betrifft ein Verfahren zur Metallisierung eines Substrats.

Zur chemischen Metallisierung von Substraten sind Palladiumbekeimungen bekannt, um eine autokatalytische chemische Abscheidung zu realisieren. Auf diese Weise können beispielsweise chemische Vernickelungen oder Verkupferungen durchgeführt werden. Die Palladiumbekeimung muss dabei in umfangreichen Prozessschritten durchgeführt werden und wird meist noch begleitet von zusätzlichen Konditionierungs- und Beschleunigungsprozessen. Die Aktivierung mit einer Palladiumbekeimung wird unterschieden in ionogene Aktivierung (hier erfolgt die Reduzierung der auf der Oberfläche anhaftenden Pd²⁺- Ionen durch Natriumhypophosphit bzw. Zinnchlorid) und kolloidale Aktivierung (die Palladiumatome werden durch Zinnionen stabilisiert).

Aus der DE 1 270 353 B ist ein Verfahren zur Herstellung metallischer, elektrisch leitender Überzüge auf nichtmetallischen Unterlagen durch chemische Abscheidung bekannt. Dabei wird die nichtmetallische Unterlage vor dem chemischen Metallisieren mit einer Lösung von Zinn(II)-chlorid oder einer ähnlich wirkenden Impfmetallverbindung in einem die Unterlage angreifenden Lösungsmittel behandelt und mit Palladiumchlorid aktiviert, so dass Palladiumkeime für die anschließende Metallisierung in die Oberfläche eingebettet werden.

Aus der DE 34 40 176 A1 ist ein behandeltes Substrat bekannt, welches zur Anwendung eines stromlosen Überziehens mit einem leitfähigen Material zum Erzeugen einer metallüberzogenen Platte zum Herstellen einer Leiterplatte mit einem aus der leitfähigen Überzugsschicht gebildeten Leitungsmuster geeignet ist. Das behandelte Substrat weist eine aus feinen Teilchen aus reduzierbarem Metalloxid, die lokal nur auf der Oberfläche der isolierenden Basis verteilt sind, bestehende Metalloxidschicht auf. Die feinen Teilchen sind teilweise in einer Randschicht der isolierenden Basis eingebettet und die übrigen Bereiche stehen frei über die Oberfläche der isolierenden Basis hervor. Das Verfahren zum Herstellen des behandelten Substrats umfasst das Aufbringen der Metalloxidschicht in einem physikalischen Aufdampfverfahren, bei dem das ionisierte Metalloxid auf die Oberfläche der isolierenden Basis geschleudert wird. Das physikalische Aufdampfverfahren kann ein Reaktions-Aufbring-Verfahren, ein lonen-Überzugs-Verfahren oder ein Aufspritz-Verfahren sein.

Aus der DE 10 2009 030 876 A1 ist ein Verfahren zum Beschichten eines Substrats bekannt, bei dem aus einem Arbeitsgas ein Plasmastrahl erzeugt wird, wobei mindestens ein Precursormaterial dem Arbeitsgas und/oder dem Plasmastrahl zugeführt und im Plasmastrahl zur Reaktion gebracht wird und wobei mindestens ein Reaktionsprodukt mindestens eines der Precursoren auf mindestens einer Oberfläche des Substrats und/oder auf mindestens einer auf der Oberfläche angeordneten Schicht abgeschieden wird, wobei mindestens eine weitere Schicht mittels eines nasschemischen Prozesses abgeschieden wird und wobei die Abscheidung der Schichten bei Atmosphärendruck durchgeführt wird.

Aus der US 2007/0190362 A1 sind eine Vorrichtung und ein Verfahren zum selektiven Bilden einer metallisierten Funktion, wie eine elektrischen VerbindungsFunktion auf einer elektrisch isolierenden Oberfläche eines Substrats bekannt. Weiter ist ein Verfahren zur Bildung einer mechanisch stabilen, haftenden, oxidationsbeständigen leitfähigen Schicht selektiv auf entweder einem bestimmten Muster oder als eine konforme Deckschicht offenbart. Weiter sind eine Chemie, ein Verfahren und eine Vorrichtung offenbart, um einzelne oder deckende elektrochemisch oder stromlos plattierbare Ruthenium oder Rutheniumdioxid enthaltende Haft- und Keimschichten bereitzustellen. Die offenbarten Aspekte können für die Bearbeitung von Flachbildschirmen, Halbleitern, Solarzellenvorrichtungen oder anderer Substrate verwendet werden, insbesondere für das Aufbringen von fest haftenden Beschichtungen auf Glas sowie flexiblen Kunststoffsubstraten. Die offenbarten Aspekte können zur Bildung von elektrischen Verbindungen auf der Oberfläche des Flachbildschirms oder der Solarzelle verwendet werden.

Der Erfindung liegt die Aufgabe zu Grunde, ein verbessertes Verfahren zur Metallisierung eines Substrats anzugeben.

Die Aufgabe wird erfindungsgemäß gelöst durch ein Verfahren mit den Merkmalen des Anspruchs 1.

Vorteilhafte Ausgestaltungen der Erfindung sind Gegenstand der Unteransprüche.

Bei einem erfindungsgemäßen Verfahren zum Metallisieren eines Substrates wird mittels chemischer Gasphasenabscheidung unter Atmosphärendruckbedingungen eine Bekeimungsschicht auf einem Substrat abgeschieden, wobei in die Bekeimungsschicht Nanopartikel eingebettet werden und wobei die Nanopartikel als Keime für eine nachfolgende Beschichtung mittels chemischer Metallisierung verwendet werden.

Mit Hilfe der chemischen Gasphasenabscheidung unter Atmosphärendruckbedingungen, insbesondere mittels so genannter Freistrahlplasmen, können Bekeimungsschichten, beispielsweise SiOₓ- Schichten auf Substraten, beispielsweise Glas und PES- Gewirke (Polyester) hergestellt werden, wobei in den Bekeimungsschichten unterschiedliche Konzentrationen von Nanopartikeln, beispielsweise Silber- Nanopartikeln abgeschieden werden können. Überraschenderweise zeigte sich, dass die Nanopartikel, beispielsweise Silber- Nanopartikel in den Bekeimungsschichten als Katalysatormaterial für eine nachfolgende chemische Metallisierung dienen können. Die Konzentration der Nanopartikel in den Bekeimungsschichten wirkt sich dabei auf die erzielbare Aufwachsrate bei der chemischen Metallisierung aus. Die Leitfähigkeit dieser Metallisierungen und die Homogenität der aufwachsenden Schichten wird durch die Massenbelegung beeinflusst.

Mit Hilfe von Prozessen der plasmagestützten chemischen Gasphasenabscheidung sowohl unter Niederdruckbedingungen als auch unter Atmosphärendruckbedingungen können funktionelle Beschichtungen auf unterschiedlichen Oberflächen hergestellt werden. Bei derartigen APCVD- Schichtbildungsprozessen (APCVD - atmospheric pressure plasma chemical vapour deposition) werden Precursormaterialien beispielsweise einem Freistrahl- Plasmajet zugeführt und im Plasma schichtbildend umgesetzt. Je nach verwendetem Precursormaterial können unterschiedliche Schichten hergestellt werden. Neben der Zugabe der eigentlichen Precursormaterialien können weiterhin auch spezielle Lösungen oder Dispersionen dem Plasmajet (der Plasmaquelle) zugeführt werden. Unter Berücksichtigung der speziellen Herstellungsparameter hat dies zur Folge, dass in die aufwachsende Schichtmatrix nanopartikuläre Stoffe eingebunden werden können. Ebenso können mit Hilfe von Flammenbeschichtungsverfahren unter Atmosphärendruckbedingungen derartige Schichten abgeschieden werden.

Durch das Arbeiten bei Atmosphärendruck werden auf besonders vorteilhafte Weise ein zeitaufwändiger Prozessschritt der Evakuierung einer Prozesskammer sowie Apparaturen zur Vakuumerzeugung wie Vakuumpumpen und Prozesskammer eingespart. Dadurch lässt sich das Verfahren ohne großen Aufwand in eine Prozesskette integrieren, die eine Herstellung und Vergütung des Substrats beinhaltet.

Im Kontext der vorliegenden Erfindung sollen als Nanopartikel solche Partikel verstanden werden, deren größte Ausdehnung 100 nm nicht übersteigt. Bevorzugt werden Nanopartikel mit einer größten Ausdehnung von maximal 50 nm, besonders bevorzugt maximal 30 nm verwendet bzw. während der Abscheidung gebildet. Neben den Nanopartikeln können auch vereinzelt Partikel bzw. Agglomerationen in der Gasphase gebildet werden, deren Größe bis zu einigen Mikrometern beträgt.

Die Bekeimungsschicht kann mittels einer Flamme oder mittels eines Atmosphärendruck-Freistrahlplasmas oder, in einer nicht erfindungsgemäßen Ausführungsform, mittels eines Sol-Gel-Verfahrens oder mittels Plasmaspritzen abgeschieden werden.

Insbesondere kann die Bekeimungsschicht mittels einer Kombination aus Flammen- oder Freistrahlplasmabeschichtung und eines Sol-Gel-Verfahrens abgeschieden werden.

Die Erzeugung des Plasmas kann in einer Freistrahlplasmaquelle erfolgen. Bei diesem Verfahren wird eine Hochfrequenzentladung zwischen zwei konzentrischen Elektroden gezündet, wobei durch einen eingeleiteten Gasstrom das sich bildende Hohlkathodenplasma als Plasmajet aus der Elektrodenanordnung in aller Regel mehrere Zentimeter in den freien Raum und zur zu beschichtenden Oberfläche gerichtet herausgeführt wird. Der Precursor kann sowohl vor der Anregung in das Arbeitsgas (direct plasma processing) als auch danach in das bereits gebildete Plasma oder in dessen Nähe (remote plasma processing) eingeleitet werden. Eine weitere Möglichkeit der Plasmaerzeugung ist das Ausnutzen einer dielektrisch behinderten Entladung. Dabei wird das als Dielektrikum dienende Arbeitsgas, insbesondere Luft, zwischen zwei Elektroden hindurchgeleitet. Die Plasmaentladung erfolgt zwischen den Elektroden, welche mit hochfrequenter Hochspannung gespeist werden. Ebenso kann ein Glassubstrat selbst als Dielektrikum genutzt werden, indem der Gasstrom zwischen einer metallischen Flächenelektrode und dem flachen Glassubstrat hindurch geführt wird.

Der Precursor wird vorzugsweise im gasförmigen Zustand oder als Aerosol in das Arbeitsgas oder den Plasmastrom eingeleitet. Flüssige oder feste, insbesondere pulverförmige Precursoren sind ebenfalls einsetzbar, werden jedoch bevorzugt vor der Einleitung, beispielsweise durch Verdampfung, in den gasförmigen Zustand überführt. Ebenso kann der Precursor zunächst in ein Trägergas eingeleitet, davon mitgerissen und zusammen mit diesem in das Arbeitsgas oder den Plasmastrom eingeleitet werden.

Als Arbeitsgas können Luft, Dampf oder ein anderes Gas verwendet werden, beispielsweise Sauerstoff, Stickstoff, Edelgase, Wasserstoff, Kohlendioxid, gasförmige Kohlenwasserstoffe oder eine Mischung derselben.

Als Brenngas für die Beflammung kann beispielsweise Propan verwendet werden, wobei zur Verbrennung Luft oder Sauerstoff zugeführt werden. Das Brenngas kann mit Luft oder Sauerstoff vorgemischt werden.

Als Bekeimungsschicht kann eine oxidische Schicht, beispielsweise eine SiOₓ-Schicht oder eine TiOₓ- Schicht abgeschieden werden.

Als Precursor wird dabei bevorzugt eine silizium- oder titanorganische Verbindung verwendet, beispielsweise Hexamethyldisiloxan, Tetramethylsilan, Tetramethoxysilan oder Tetraethoxysilan bzw. Titantetraisopropanolat.

Als Bekeimungsschicht kann eine nitridische Schicht, beispielsweise eine SiN-Schicht oder eine TiN-Schicht abgeschieden werden.

Als Precursor werden dabei bevorzugt Tetramethylsilan, Monosilan, Hexamethyldisilazan und Ammoniak für SiN-Schichten bzw. Tetrakis(dimethylamino)titan, Tetrakis(diethylamino)titan, Titanhydrid und Ammoniak für TiN-Schichten eingesetzt.

Die Bekeimungsschicht kann Oxide, Nitride und/oder Carbide mindestens eines der Elemente Silizium, Titan, Zink, Wolfram enthalten.

Die in der Bekeimungsschicht abgeschiedenen Nanopartikel umfassen insbesondere eines oder mehrere der Elemente Silber, Gold, Kupfer, Zink, Zinn, Eisen, Palladium, Platin, Mangan, Vanadium.

Die Konzentration der Nanopartikel in der Bekeimungsschicht beträgt unter 100%, bevorzugt unter 15%, besonders bevorzugt unter 8%.

Die Bekeimungsschicht kann mit einer Dicke unter 5 µm, bevorzugt unter 1 µm und besonders bevorzugt unter 300 nm abgeschieden werden.

Zur Metallisierung des Substrats kann eine chemische Abscheidung mindestens eines der Elemente Kupfer, Nickel, Zinn, Zink oder Gold oder mindestens einer Legierung aus oder mit den genannten Elementen erfolgen.

Die Metallisierung kann durch eine galvanische Verstärkung mittels mindestens einem der Elemente Kupfer, Nickel, Zinn, Zink oder Gold oder mindestens einer Legierung aus oder mit den genannten Elementen ergänzt werden. Bei hinreichender Leitfähigkeit der Bekeimungsschicht kann eine galvanische Abscheidung der mindestens eines der Elemente Kupfer, Nickel, Zinn, Zink oder Gold oder mindestens einer Legierung aus oder mit den genannten Elementen auch ohne vorherige chemische Abscheidung erfolgen.

Das Verfahren ermöglicht die Beschichtung sowohl ebener als auch frei konturierbarer, beispielsweise gekrümmter Substratoberflächen.

Beispielsweise können Oberflächen aus Kunststoff, Glas, Metall, Keramik, Glaskeramik oder einem Komposit von mindestens zweien dieser Materialien, sowie Holz, künstlichem und/oder natürlichem Gestein oder Textil metallisiert werden.

Das erfindungsgemäße Verfahren ermöglicht das direkte "Schreiben" von metallisch leitfähigen Konturen auf beliebig konturierte Oberflächen von Substraten. Durch eine vorgegebene Kontur auf dem Substrat, die mittels chemischer Gasphasenabscheidung (beispielsweise APCVD) abgefahren wird, kann eine Bekeimungsschicht mit Nanopartikeln vollflächig oder gezielt partiell auf das Substrat aufgebracht werden. In einem nachfolgenden nasschemischen Metallisierungsprozess erfolgt die Metallisierung nur in den Bereichen, in denen zuvor die CVD-Beschichtung stattfand. Dies ermöglicht den Verzicht auf Ätzschritte zur Strukturierung einer metallischen Oberfläche.

Es können frei wählbare metallische Strukturen auf Substraten generiert werden, auch auf komplexen 3D-Geometrien. Auf diese Weise sind Metallisierungen dreidimensionaler Spritzgussteile, beispielsweise dreidimensionale spritzgegossene Schaltungen, so genannte MID (molded interconnect devices) realisierbar.

Das erfindungsgemäße Verfahren ermöglicht die Beschichtung beliebiger Kunststoffteile, die im Spritzguss hergestellt sind. Anders als im Stand der Technik bekannte Metallisierungsverfahren ist das erfindungsgemäße Verfahren unabhängig vom Werkstoff ABS (Acrylnitril- Butadien- Styrol). Stattdessen können auch Substrate aus PP (Polypropylen) metallisiert werden.

Ebenso können Substrate in Form von Fasern und Textilien metallisiert werden, beispielsweise zur Herstellung beheizbarer Textilien.

Durch die mittels CVD abgeschiedene Bekeimungsschicht kann die Haftung der chemisch aufgebrachten Metallisierungsschicht verbessert werden.

Durch das erfindungsgemäße Verfahren kann auf eine Palladiumbekeimung verzichtet werden, so dass Materialkosten wesentlich reduziert werden. Beispielsweise ist die Verwendung von Silbernitratlösung bei einem APCVD- Verfahren erheblich preisgünstiger.

Es können auch andere Metallverbindungen verwendet werden, um Nanopartikel in die Bekeimungsschicht einzubetten, wie beispielsweise Metallnitrate / acetate / alkoholate, und/oder wasserlösliche und/oder in Alkoholen lösliche Metallverbindungen, sowie stabile Metall- Nanopartikel Dispersionen.

Mittels des erfindungsgemäßen Verfahrens können metallisch leitfähige Bereiche auf Produktverpackungen abgeschieden werden, beispielsweise wird eine Kontur über einen Verschluss der Verpackung "geschrieben", die beim Öffnen der Verpackung geteilt wird. Bei der verschlossenen Verpackung ist die abgeschiedene Kontur leitfähig, während sie bei einer geöffneten und gegebenenfalls wiederverschlossenen Verpackung unterbrochen und somit nicht mehr leitfähig ist. Auf diese Weise kann die Originalität der Verpackung und die Unversehrtheit des verpackten Produktes überprüft werden.

Im Folgenden werden Ausführungsbeispiele der Erfindung näher dargestellt.

### Beispiel 1:

Auf einem Glas-Substrat wird eine SiOₓ-Bekeimungsschicht abgeschieden, in der Silber-Nanopartikel eingebettet werden. Anschließend erfolgt eine chemische Verkupferung.

Die Bekeimungsschicht wurde mit Hilfe eines Freistrahlplasma-Jets unter Atmosphärendruckbedingungen durch mäanderförmiges Abrastern der Substratoberfläche gleichmäßig abgeschieden. Als schichtbildender Precursor wird dem Plasma oder einem zur Bildung des Plasmas verwendeten Arbeitsgas Hexamethyldisiloxan (HMDSO) mit einer definierten Dosis zugeführt. Als Silberlieferant wird eine Silbernitratlösung verwendet, die Dosierrate kann für verschiedene Substrate variiert werden. Die Beschichtung kann mit folgenden Parametern erfolgen:
- Brennerleistung: 250 W
- Prozessgasdruck: 6 bar (Luft)
- Durchsatz des Precursor-Trägergases: 200 ml/min
- Dosierrate der AgNO₃-Lösung: zwischen 0 und 100 µl/min variabel

Die so vorbehandelten Glas-Substrate weisen an der Oberfläche eine SiOₓ-Schicht auf, die Silber-Nanopartikel enthält. Diese Nanopartikel können für eine nachfolgende chemische Verkupferung als Keime genutzt werden. Die Verfahrensparameter für die chemische Verkupferung können wie folgt gewählt werden:
- Kupfersulfat- Elektrolyt mit 22 g/l CuSO₄, welcher durch Tetramethylthiuramidsulfid stabilisiert und mit Formalin aktiviert wird.
- Arbeitstemperatur: Raumtemperatur bis 45°C

Nach der chemischen Verkupferung zeigen die so behandelten Glas-Substrate Kupferbeschichtungen auf ihrer Oberfläche, deren Schichtdicke - nach konstanter Tauchzeit - direkt proportional zur Silberdosierrate bei der Abscheidung der Bekeimungsschicht ist.

### Beispiel 2:

Auf einem Substrat aus PES- Gewirke wird eine SiOₓ- Bekeimungsschicht abgeschieden, in der Silber- Nanopartikel eingebettet werden. Anschließend erfolgt eine chemische Verkupferung.

Die Abscheidung der Bekeimungsschicht und die chemische Metallisierung erfolgt analog zum Ausführungsbeispiel 1, als Substrat wird jedoch ein textiles Substrat in Form von PES- Gewirke verwendet.

### Beispiel 3:

Auf einem Substrat aus PES- Gewirke wird eine SiOₓ-Bekeimungsschicht abgeschieden, in der Silber-Nanopartikel eingebettet werden. Anschließend erfolgt eine chemische und galvanische Verkupferung.

Die Abscheidung der Bekeimungsschicht und die chemische Verkupferung erfolgt analog zum Ausführungsbeispiel 2. Nach der chemischen Verkupferung erfolgt eine galvanische Nachverstärkung mit folgenden Parametern:

| | |
|---|---|
| - Elektrolyttemperatur: | 20 °C bis 35 °C, insbesondere 25°C |
| - Stromdichte: | 1 A/dm² bis 5 A/dm², beispielsweise 2 A/dm² |
| - Beschichtungszeit: | je nach gewünschter Schichtdicke 10 min bis 30 min, beispielsweise 10 min |

Auf diese Weise gelingt es, die chemisch erzeugte Kupfer-Startschicht galvanisch zu verstärken.

Für den Elektrolyt können folgende Parameter verwendet werden:

| | | |
|---|---|---|
| • | 200 g/l | Kupfersulfat |
| • | 80 g/l | Schwefelsäure |
| • | 100 mg/l | Natriumchlorid |

### Beispiel 4:

Auf einem Substrat, beispielsweise aus Glas, wird eine SiOₓ-Bekeimungsschicht abgeschieden, in der Palladium oder Kupfer-Nanopartikel eingebettet werden. Anschließend erfolgt eine chemische Verkupferung.

Die APCVD-Beschichtung erfolgt analog zum Ausführungsbeispiel 1, jedoch bei reduzierenden Bedingungen unter Verwendung von Stickstoff bzw. Edelgasen als Prozessgase, sowie Palladiumnitrat bzw. Kupfernitrat als Precursorbestandteile. Die Metallisierung erfolgt anschließend analog zu dem Ausführungsbeispiel 1.

### Beispiel 5:

Auf einem Substrat, beispielsweise aus Glas, wird eine SiOₓ-Bekeimungsschicht abgeschieden, in der Palladium oder Eisen-Nanopartikel eingebettet werden. Anschließend erfolgt eine chemische Vernickelung.

Die APCVD-Beschichtung erfolgt analog zum Ausführungsbeispiel 1, jedoch bei reduzierenden Bedingungen unter Verwendung von Stickstoff bzw. Edelgasen als Prozessgase, sowie Palladiumnitrat bzw. Eisennitrat als Precursorbestandteile. Für die anschließende chemische Vernickelung können beispielsweise folgende Verfahrensparameter gewählt werden:

| | | |
|---|---|---|
| - | Nickelsulfat(II)-sulfat-hexahydrat | 60g/l- 120g/l |
| - | Natriumhypophosphit-1-hydrat | 45 g/l - 90 g/l |
| - | Natriumacetat | 10g/l- 20g/l |
| - | Ammoniumsulfat-3-hydrat | 5g/l - 15g/l |
| - | Borsäure | 2,5g/l - 7g/l |
| - | Beschichtungstemperatur | 45°C - 65°C |
| - | Beschichtungszeit | 10 - 60 min |

### Beispiel 6:

Auf einem dreidimensionalen Spritzgussteil aus Kunststoff wird eine SiOx-Bekeimungsschicht abgeschieden, in der Silber-Nanopartikel eingebettet werden. Die Abscheidung dieser Bekeimungsschicht erfolgt durch direktes Schreiben mit einem Freistrahlplasma, indem der Plasmastrahl entlang bestimmter Konturen gefahren und damit eine aktivierte Struktur erzeugt wird (im Sinne der Bekeimung). Anschließend erfolgt eine chemische Verkupferung und optional eine galvanische Verstärkung mit Kupfer und/oder Nickel.

Die APCVD-Beschichtung erfolgt analog zu Ausführungsbeispiel 1. Die chemische Metallisierung erfolgt anschließend analog zu Ausführungsbeispiel 1

## Patentansprüche

1. Verfahren zum Metallisieren eines Substrates, wobei mittels chemischer Gasphasenabscheidung mittels einer Flamme oder mittels eines Atmosphärendruck-Freistrahlplasmas unter Atmosphärendruckbedingungen eine Bekeimungsschicht auf einem Substrat abgeschieden wird, wobei in die Bekeimungsschicht Nanopartikel eingebettet werden und wobei die Nanopartikel als Keime für eine nachfolgende Beschichtung mittels chemischer Metallisierung verwendet werden.

2. Verfahren nach Anspruch 1, **dadurch gekennzeichnet, dass** die Bekeimungsschicht mittels der chemischen Gasphasenabscheidung und einem Sol-Gel-Verfahren oder mittels der chemischen Gasphasenabscheidung und Plasmaspritzen abgeschieden wird.

3. Verfahren nach einem der vorangehenden Ansprüche, **dadurch gekennzeichnet, dass** als Bekeimungsschicht eine oxidische Schicht abgeschieden wird.

4. Verfahren nach einem der vorangehenden Ansprüche, **dadurch gekennzeichnet, dass** die Bekeimungsschicht Oxide, Nitride und/oder Carbide mindestens eines der Elemente Silizium, Titan, Zink oder Wolfram enthält.

5. Verfahren nach einem der vorangehenden Ansprüche, **dadurch gekennzeichnet, dass** Nanopartikel umfassend eines oder mehrere der Elemente Silber, Kupfer, Zink, Zinn, Eisen, Palladium, Platin, Mangan, Vanadium in die Bekeimungsschicht eingebettet werden.

6. Verfahren nach einem der vorhergehenden Ansprüche, **dadurch gekennzeichnet, dass** die Volumen-Konzentration der Nanopartikel in der Bekeimungsschicht unter 100%, bevorzugt unter 15%, besonders bevorzugt unter 8% liegt.

7. Verfahren nach einem der vorhergehenden Ansprüche, **dadurch gekennzeichnet, dass** die Bekeimungsschicht mit einer Dicke unter 5 µm, bevorzugt unter 1 µm und besonders bevorzugt unter 300 nm abgeschieden wird.

8. Verfahren nach einem der vorhergehenden Ansprüche, **dadurch gekennzeichnet, dass** zur Metallisierung eine chemische Abscheidung mindestens eines der Elemente Kupfer, Nickel, Zinn, Zink oder Gold oder mindestens eine Legierung aus oder mit den genannten Elementen durchgeführt wird.

9. Verfahren nach einem der vorhergehenden Ansprüche, **dadurch gekennzeichnet, dass** die Metallisierung durch eine galvanische Verstärkung mittels mindestens einem der Elemente Kupfer, Nickel, Zinn, Zink oder Gold oder mindestens einer Legierung aus oder mit den genannten Elementen ergänzt wird.

10. Verwendung des Verfahrens nach einem der Ansprüche 1 bis 9 zur Herstellung einer dreidimensionalen spritzgegossenen Schaltung.

11. Verwendung des Verfahrens nach einem der Ansprüche 1 bis 9 zur Herstellung leitfähiger Textilien.

12. Verwendung des Verfahrens nach einem der Ansprüche 1 bis 9 zur Herstellung eines Originalitätsverschlusses einer Produktverpackung.

## Claims

1. Method for the metallization of a substrate, wherein a seed layer is deposited on a substrate by means of chemical vapour deposition by means of a flame or by means of an atmospheric-pressure free jet plasma under atmospheric pressure conditions, wherein nanoparticles are embedded in the seed layer, and wherein the nanoparticles are used as seeds for subsequent coating by means of chemical metallization.

2. Method according to Claim 1, **characterized in that** the seed layer is deposited by means of the chemical vapour deposition and a sol-gel process or by means of the chemical vapour deposition and plasma spraying.

3. Method according to either of the preceding claims, **characterized in that** an oxidic layer is deposited as the seed layer.

4. Method according to one of the preceding claims, **characterized in that** the seed layer contains oxides, nitrides and/or carbides of at least one of the elements silicon, titanium, zinc or tungsten.

5. Method according to one of the preceding claims, **characterized in that** nanoparticles comprising one or more of the elements silver, copper, zinc, tin, iron, palladium, platinum, manganese, vanadium are embedded in the seed layer.

6. Method according to one of the preceding claims, **characterized in that** the volumetric concentration of the nanoparticles in the seed layer is below 100%, preferably below 15%, particularly preferably below 8%.

7. Method according to one of the preceding claims, **characterized in that** the seed layer is deposited with a thickness of less than 5 µm, preferably less than 1 µm and particularly preferably less than 300 nm.

8. Method according to one of the preceding claims, **characterized in that** at least one of the elements copper, nickel, tin, zinc or gold or at least one alloy consisting of or comprising said elements is chemically deposited for the metallization.

9. Method according to one of the preceding claims, **characterized in that** the metallization is supplemented by thickening by electroplating by means of at least one of the elements copper, nickel, tin, zinc or gold or at least one alloy consisting of or comprising said elements.

10. Use of the method according to one of Claims 1 to 9 for producing a three-dimensional, injection-moulded circuit.

11. Use of the method according to one of Claims 1 to 9 for producing conductive textiles.

12. Use of the method according to one of Claims 1 to 9 for producing a tamperproof seal for product packaging.

## Revendications

1. Procédé de métallisation d'un substrat, dans lequel, au moyen d'un dépôt chimique en phase vapeur, à l'aide d'une flamme ou d'un plasma à jet libre sous la pression atmosphérique, on dépose dans les conditions d'une pression atmosphérique une couche de germination sur un substrat, ce à l'occasion de quoi des nanoparticules sont incorporées dans la couche de germination, et les nanoparticules sont utilisées en tant que germes pour un revêtement ultérieur à l'aide d'une métallisation chimique.

2. Procédé selon la revendication 1, **caractérisé en ce que** la couche de germination est déposée à l'aide du dépôt chimique en phase vapeur et d'un procédé sol-gel, ou à l'aide d'un dépôt chimique en phase vapeur et d'une projection plasma.

3. Procédé selon l'une des revendications précédentes, **caractérisé en ce qu'**on dépose en tant que couche de germination une couche d'oxydes.

4. Procédé selon l'une des revendications précédentes, **caractérisé en ce que** la couche de germination contient des oxydes, des nitrures et/ou des carbures d'au moins l'un des éléments silicium, titane, zinc ou tungstène.

5. Procédé selon l'une des revendications précédentes, **caractérisé en ce que** des nanoparticules comprenant un ou plusieurs des éléments argent, cuivre, zinc, étain, fer, palladium, platine, manganèse, vanadium sont incorporées dans la couche de germination.

6. Procédé selon l'une des revendications précédentes, **caractérisé en ce que** la concentration volumique des nanoparticules dans la couche de germination est inférieure à 100 %, de préférence inférieure à 15 %, d'une manière particulièrement préférée inférieure à 8 %.

7. Procédé selon l'une des revendications précédentes, **caractérisé en ce que** la couche de germination est déposée avec une épaisseur inférieure à 5 µm, de préférence inférieure à 1 µm et d'une manière particulièrement préférée inférieure à 300 nm.

8. Procédé selon l'une des revendications précédentes, **caractérisé en ce que**, pour la métallisation, on procède à un dépôt chimique d'au moins l'un des éléments cuivre, nickel, étain, zinc ou or, ou d'au moins un alliage des éléments mentionnés ou avec ceux-ci.

9. Procédé selon l'une des revendications précédentes, **caractérisé en ce que** la métallisation est complétée par un renforcement galvanique à l'aide d'au moins des éléments cuivre, nickel, étain, zinc ou or ou d'au moins un alliage constitué des éléments mentionnés ou avec ceux-ci.

10. Utilisation du procédé selon l'une des revendications 1 à 9 pour fabriquer un circuit tridimensionnel moulé par injection.

11. Utilisation du procédé selon l'une des revendications 1 à 9 pour fabriquer des textiles conducteurs.

12. Utilisation du procédé selon l'une des revendications 1 à 9 pour fabriquer une bague d'inviolabilité d'un emballage d'un produit.
